Europäisches Patentamt

European Patent Office

Office européen des brevets

(19)

(11) **EP 0 700 164 B1**

(12) **FASCICULE DE BREVET EUROPEEN**

(45) Date de publication et mention
de la délivrance du brevet:
**12.02.1997 Bulletin 1997/07**

(51) Int Cl.⁶: **H03M 13/00**

(21) Numéro de dépôt: **95402011.1**

(22) Date de dépôt: **05.09.1995**

(54) **Circuit de traitement de signal pour mettre en oeuvre un algorithme de Viterbi**

Signalverarbeitungsschaltung zur Durchführung des Viterbi Algorithmus

Signal processing circuit to implement a Viterbi algorithm

(84) Etats contractants désignés:
**DE FR GB IT**

(30) Priorité: **05.09.1994 FR 9410620**

(43) Date de publication de la demande:
**06.03.1996 Bulletin 1996/10**

(73) Titulaire: **SGS-THOMSON MICROELECTRONICS
S.A.
94250 Gentilly (FR)**

(72) Inventeur: **Cartier, Michel
F-75116 Paris (FR)**

(74) Mandataire: **Schmit, Christian Norbert Marie
Cabinet Ballot-Schmit
7, rue Le Sueur
75116 Paris (FR)**

(56) Documents cités:
EP-A- 0 391 354        EP-A- 0 448 809
WO-A-93/19418        US-A- 5 220 570

• GLOBECOM '90: IEEE GLOBAL
TELECOMMUNICATIONS CONFERENCE AND
EXHIBITION. 'COMMUNICATIONS:
CONNECTING THE FUTURE' (CAT.
NO.90CH2827-4), SAN DIEGO, CA, USA, 2-5 DEC.
1990, vol. 2/3, ISBN 0-87942-632-2, 1990, NEW
YORK, NY, USA, IEEE, USA, pages 1333-1337
vol.2, XP 000221100 LOU H ET AL 'A
programmable parallel processor architecture
for Viterbi detection'
• PATENT ABSTRACTS OF JAPAN vol. 018 no.
608 (E-1633) ,18 Novembre 1994 & JP-A-06
232923 (SONY CORP) 19 Août 1994,

## Description

La présente invention a pour objet un circuit de traitement de signal pour mettre en oeuvre un algorithme de Viterbi. Un tel algorithme est particulièrement utilisé pour la correction d'erreurs dans le décodage des signaux codés avec des codes convolutifs, ainsi que dans le décodage des signaux modulés codés en treillis. Il sert également dans l'égalisation de canal et dans la reconnaissance vocale. L'invention concerne particulièrement les trois premières applications encore qu'elle peut également concerner la quatrième.

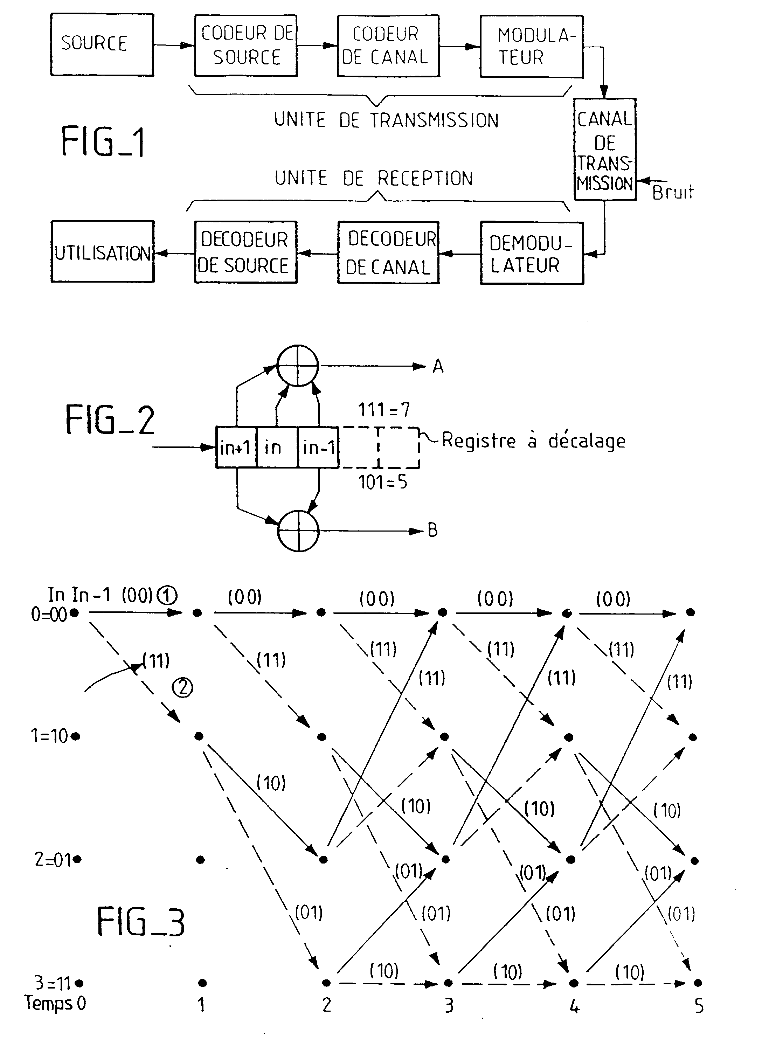

L'invention sera ainsi expliquée dans le cadre d'un système de décodage de signaux transmis par un système de transmission. Les signaux dont il est question sont des signaux numériques. Un système de communication numérique, montré sur la figure 1, comporte une source de signal numérique en liaison avec une unité de transmission. L'unité de transmission est couplée à un canal de transmission. Le canal de transmission est également couplé à une unité de réception qui débite des signaux utilisables par un utilisateur. La source produit un message consistant en un flot de bits. Afin que la quantité d'information reçue par l'utilisateur soit la plus correcte possible, la première opération effectuée par l'unité de transmission est un codage de source, ou compression, qui a pour but de réduire la quantité d'information à transmettre. En outre, l'unité de transmission transforme avec un codeur de canal le message à transmettre en un message qui est moins vulnérable aux perturbations du canal. Ceci est effectué au moyen d'un codage de correction d'erreurs qui ajoute de la redondance au message. La troisième opération effectuée par l'unité de transmission concerne la modulation qui permet d'ajuster le signal transmis aux caractéristiques du canal. Celle-ci met en oeuvre des décalages de fréquence. Le canal est un médium physique qui permet la communication d'un point à un autre. Le canal peut comporter des connexions filaires ou bien un espace de transmission hertzienne.

L'unité de réception exécute des opérations réciproques. Elle comporte notamment un démodulateur qui peut effectuer une égalisation de canal et dont la fonction est de purifier les bits reçus. Un algorithme de Viterbi peut être utilisé pour exécuter une telle égalisation. Un décodeur de canal connecté au démodulateur, détecte et corrige les erreurs de bit apportées par le canal. Il est notamment plus compliqué que le codeur de canal. Enfin, un décodeur de source connecté au décodeur de canal reproduit le signal original. Il est en général moins compliqué que le codeur de source.

Il y a d'une manière connue, quatre types de modulation :

.   la modulation d'amplitude (AM) ;
.   la modulation de fréquence (FSK) ;
.   la modulation de phase (PSK) ; et
.   la modulation de phase et d'amplitude (QAM).

En modulation de phase, la phase de la porteuse est transmise avec des décalages, par exemple, en phase ou en opposition de phase selon qu'il y a lieu de transmettre un 1 ou un 0. Ceci correspond à la modulation de phase binaire (BPSK). Mais il est aussi connu d'utiliser les décalages de phase moins importants de la porteuse. Ainsi, en modulation de phase en quadrature (QPSK), on peut transmettre deux bits avec un seul signal de phase. En pratique des problèmes de réalisation technique limitent les décalages de phase à une modulation de type 8PSK permettant de transmettre trois bits par seconde et par Hertz.

Pour une meilleure efficacité spectrale, on utilise de la modulation d'amplitude et de phase dite QAM, notamment la modulation dite 16QAM qui permet d'envoyer jusqu'à 4 bits par seconde et par Hertz. Dans le domaine de la télévision haute définition, il est connu des modulations de type 1024QAM. De tels types de modulation permettent notamment d'envoyer des débits de 30Mbits par seconde dans une bande passante de 8MHz.

Il y a trois types de canaux de transmission. Quand l'unité de transmission a une liaison directe et unique avec l'unité de transmission, le canal est dit gaussien. Il est connu qu'un tel canal ajoute un bruit gaussien au signal modulé transmis. Par contre, lorsque l'unité de réception est connectée à l'unité de transmission par un canal non unique, produisant notamment des échos par réflexion de signal, ce canal est dit un canal de Rice. Enfin, lorsqu'il n'y a pas de liaison directe, le canal est dit un canal de Rayleigh. Ces deux derniers canaux sont des canaux à évanouissement et doivent être notamment considérés quand il s'agit de communication avec des mobiles, en particulier dans le cas du téléphone de type GSM.

Un autre défaut présenté par les canaux de transmission est l'interférence inter-symbole qui est d'autant plus sensible que la période du signal transmis et basse par rapport à la réponse impulsionnelle du canal. Cependant, en fonction de la connaissance de cette réponse impulsionnelle, il est possible de soustraire des signaux reçus la contribution due à des signaux précédents. Ce procédé est appelé l'égalisation. Un tel procédé peut être mis en oeuvre de différentes façons, plus ou moins compliquées. Une des façons les plus adéquates consiste à mettre en oeuvre l'algorithme de Viterbi.

L'aspect de base de la correction d'erreurs est la redondance. Sans redondance, chaque bit du message est essentiel à la compréhension du message. Le but de la redondance est de ne pas laisser l'apparition d'erreurs compromettre la signification de ce message. La redondance est introduite par un codage effectué sur le message. Il y a deux types de codage, les codages de blocs et les codages convolutifs. Les codages de blocs consistent, connaissant K bits à transmettre, à créer N-K bits de redondance. Le bloc transmis a alors une longueur de N bits. Habituellement, les N-K bits sont le reste d'une division polynomiale des K bits à transmettre par un polynôme de référence. On définit un taux R de code comme le rapport entre le nombre de bits d'information à transmettre, K, au nombre de bits transmis, N. R égale alors K/N.

Les messages de K bits peuvent avoir $2^K$ valeurs différentes. Quand on code un mot de K bits sur N bits, on obtient un certain nombre de mots interdits : ce nombre vaut $2^N - 2^K$. Quand un mot interdit est reçu à la place d'un mot vrai attendu, on mesure un écart entre ce mot interdit et des mots vrais possibles. On retient comme mot vrai, le mot vrai la plus proche. On définit de ce fait, une distance minimale de codage qui est le nombre minimum de bits différents pour passer d'un mot possible à un autre. Les codages de blocs les plus connus sont le codage de parité, le codage de Hamming, le codage de Golay, le codage dit BCH, et le codage Reed-Solomon. Ce dernier est un codage parfait dans le sens qu'il utilise 2t bits de redondance pour corriger t erreurs. Les codages de blocs sont utilisés dans les transmissions spatiales, dans les transmissions par câbles, dans la télévision haute définition et dans le stockage de données dans les mémoires dynamiques et sur les disques optiques. Il n'y a pas de standard. Chaque utilisation requiert son propre code.

Les codes convolutifs consistent également à produire à partir de K bits à transmettre N bits codés (N>K) dits symboles. La particularité de ces codages convolutifs est que les N-K bits ajoutés, et les K bits transmis dépendent tous indirectement des K bits à transmettre. Le principe de codage de ces codes convolutifs est représenté sur la figure 2. Dans cette figure K = 1 et N = 2. Le taux de 1/2 sera considéré dans tout ce qui suit mais il n'est pas restrictif. Un dispositif de codage de ce type, comporte un registre à décalage à m+1 étages et un circuit logique de combinaison, ici deux OU Exclusif, pour produire les symboles transmis, ici A,B. Une différence principale entre les codages de blocs et les codages convolutifs se trouve dans le fait que les K bits d'informations ne sont donc pas transmis tels quels mais sous une forme convoluée avec des bits précédents. Dans les codages convolutifs, certaines transitions dans les symboles transmis sont interdites. Des algorithmes de décodage en tiennent compte pour retrouver la réalité d'un message à transmettre. A l'opposé des codages de blocs, les codages convolutifs sont bien adaptés à la transmission continue. Ils donnent une correction grossière.

Les systèmes de correction d'erreurs ajoutent toujours de la redondance. Il y a deux moyens pour transmettre cette redondance. Soit la bande passante nécessaire pour transmettre les informations est augmentée, soit le type de modulation est changé de façon a passer d'une modulation d'efficacité spectrale basse à une modulation d'efficacité spectrale plus haute. La seconde méthode est appelée la modulation codée.

Ainsi, l'insertion d'un code convolutif de taux 1/2 dans un système de modulation binaire de phase double la bande passante. Dans ce cas, l'utilisation d'une modulation de phase en quadrature conduit à nouveau à la même bande passante qu'avec le système non codé.

Mais, au fur et à mesure que la constellation d'une modulation de type QAM contient un plus grand nombre de points, ces points sont les plus proches les uns des autres et leur immunité au bruit est réduite. Heureusement, les possibilités de correction d'erreurs compensent plus que cette perte. Quand le codage utilisé est un codage de blocs, on parlera de modulation codée en blocs. Quant le code utilisé est un code convolutif, on parlera de modulation codée en treillis. Dans ce dernier cas, l'algorithme de Viterbi est utilisé dans le décodage. L'application principale est la norme dite V32 : une modulation 16QAM a été remplacé par une modulation 32QAM avec m=4, R=4/5.

On va montrer dans la suite de cet exposé le principe de l'algorithme de Viterbi, ainsi que les modifications de cet algorithme pour l'utiliser pour décoder les informations modulées codées en treillis, ou pour effectuer une égalisation de canal. Toutes les explications suivantes devront être comprises, sans perte de leur généralité, sur la base de l'exemple simple présenté en regard de la figure 2. Dans celui-ci le registre à décalage a trois cases, m=2, alors qu'en pratique il en a cinq, ou autre.

Sur la figure 3, on considère les transitions qui se produisent dans le registre à décalage. Elles sont présentées en fonction des valeurs possibles des doublets (in, in-1) au fur et à mesure de l'injection des bits et donc de l'évolution du temps.

Le circuit de la figure 2 comporte un registre à décalage à trois étages. Les sorties de chacun de ces étages sont reliées aux entrées d'un premier OU Exclusif qui délivre un signal A ; les sorties du premier et du troisième étage sont par ailleurs reliées aux entrées d'un autre OU Exclusif qui délivre un signal B. Les signaux A et B sont transmis par le canal. Ainsi, pour un bit de message injecté, il y a deux bits A et B de symbole émis. On rappelle que la fonction de transfert d'un OU Exclusif est de produire un 1 en sortie dès que ses deux entrées sont en présence d'états différents. Si les états à ses entrées sont identiques, le OU Exclusif produit un état 0. Un OU Exclusif à trois entrées doit être compris comme étant constitué d'un premier OU Exclusif à deux entrées et dont la sortie est connectée à un deuxième OU Exclusif qui reçoit par ailleurs la troisième entrée appliquée au OU Exclusif à trois entrées. Le choix des cases du registre à décalage prises comme entrées des OU exclusifs peut se présenter sous une forme mathématique par un polynôme dit polynôme générateur.

Le diagramme de la figure 3 montre les sorties A, B produites au fur et à mesure de l'évolution des bits in et in-1 dans le registre à décalage. Ainsi au départ, assumant qu'il y a 00 en in et in-1, l'arrivée d'un 0 en in+1 provoquera un état (00) pour A,B dans la branche indiquée par un 1 entouré. Par contre l'arrivée d'un 1 pour in+1 provoque un état (11) dans la branche indiquée par un 2 entouré. Si on est dans cette dernière situation, à l'étape suivante, le contenu in, in-1 est alors égal à 1,0, est non plus à 0,0. A partir de ce dernier état, on peut soit introduire un nouveau 0, soit introduire un autre 1 comme valeur de in+1. Les états possible du registre à décalage sont indiqués dans les différentes lignes référencées 0,1,2, ou 3 selon la valeur en mode binaire des cases in, in-1 du registre auxquelles on aboutit ou d'où on part. On retiendra en outre que, dans cette simplification de représentation, les poids binaires forts sont à droite, les poids faibles à gauche.

La présentation de ce treillis fait déjà apparaître certaines transitions interdites. Ainsi, connaissant un état de symboles A,B (0,0), l'injection de bits supplémentaires, permet d'obtenir un état nouveau de symboles qui est soit (0,0) ou (1,1) mais qui ne peut pas être (0,1). La détection d'un tel état interdit, à un tel moment de la réception, conduirait à la détection de la présence d'une erreur.

Les états du registre à décalage sont appelés des noeuds. Les transitions d'un noeud à l'autre sont appelées des branches. Par exemple, on a déjà décrit la branche entourée par un 1 et la branche entourée par un 2. La figure totale est un treillis. On conçoit par ailleurs qu'un ensemble unique d'informations binaires donne naissance à un chemin unique dans le treillis. On dira que les symboles sont les données encodées disponibles à la sortie des OU Exclusifs.

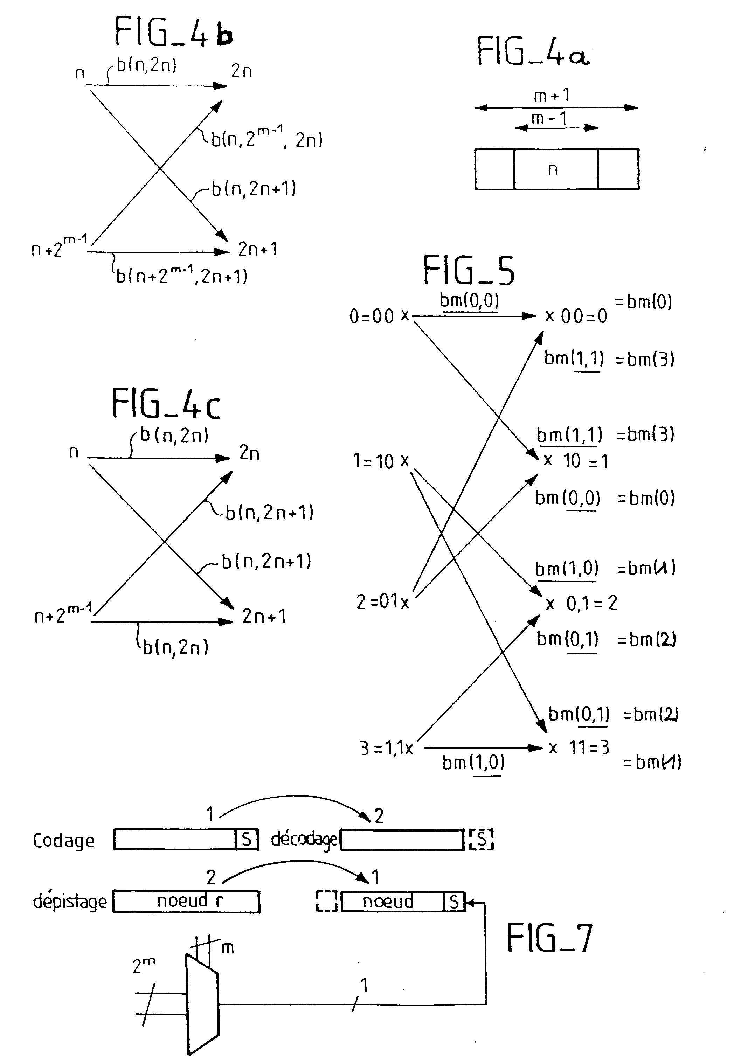

L'image généralisée de treillis d'un code convolutif de longueur de contrainte m et de taux 1/2 peut être résumée par les figures 4a à 4b. La figure 4a représente le registre à décalage comportant m+1 cases. Dans les m-1 cases centrales, une valeur n est stockée pour représenter la valeur du noeud. Quand m=2, la valeur de n ne peut être que 0 ou 1. Le bit le plus significatif est à droite, comme indiqué précédemment, le bit de poids fort est le premier introduit dans le registre.

La signification de la figure 4b, est que lorsqu'un bit nouveau est introduit, un noeud, qui par ailleurs ne peut avoir comme valeur que n ou $n+2^{m-1}$, selon que le bit sortant du registre à décalage est un 0 ou un 1, ne peut devenir qu'un noeud de valeur 2n ou de valeur 2n+1 respectivement, le facteur reflétant le décalage effectué dans le registre. On peut le vérifier facilement avec la figure 3 où le noeud de départ valait 0. Il ne peut que devenir un noeud 2n, c'est à dire 2 x 0 = 0, ou un noeud de valeur 2n+1 c'est à dire ici 1. Si on considère le noeud de valeur 1, sa valeur ne peut se transformer qu'en 2n=2 (branche marquée (1,0) sur la figure 3), ou un noeud de valeur 2n+1=3 (branche marquée (0,1) sur la figure 3). De même, si on considère le noeud de valeur 2, ce noeud correspond, dans la figure 4a à n=0, donc à un noeud après transition qui vaut soit 2n, donc 0 lui aussi, soit 2n+1, donc 1. Ceci est visible avec les branches partant du noeud 2 sur la figure 3. En ce qui concerne le noeud de valeur 3, avec n=1 selon les considérations précédentes, il ne peut évoluer que vers le noeud de valeur 2n=2 ou vers le noeud de valeur 2n+1=3. Ceci est également visible sur la figure 3.

On retiendra donc la formule générale représentée par la figure 4b pour l'évolution des noeuds au fur et à mesure de l'arrivée des bits dans le registre à décalage. On notera par ailleurs, que cette formule est valable quel que soit le nombre d'étages du registre à décalage. On définit par ailleurs, comme valeur de branche b(x,y) la valeur du couple de signaux A,B produit lorsque le noeud passe d'une valeur x à une valeur y. La figure 4b montre, d'une manière théorique, les valeurs de ces branches.

Pour simplifier le décodage et donc les explications, on retiendra de préférence dans des circuits de combinaison logique, les circuits tels que la première case et la dernière case du registre à décalage sont reliés chacun aux deux (ou plus) OU Exclusifs produisant respectivement les signaux A,B (ou plus). Il résulte de cette condition que les calculs des symboles sont simplifiés. La branche $b(n+2^{m-1}, 2n)$ correspond à la première case du registre à décalage à 0 et à la dernière égale à 1. Le OU Exclusif entre ces deux bits vaut 1, ce qui est également le cas de la branche $b(n, 2^{n+1})$ qui correspond à une première case égale à 1 et à une dernière case egale à 0. De même la branche $b (n+2^{m-1}, 2n+1)$ présente un 1 en première et dernière case, donc le OU Exclusif vaut 0 comme la branche b(n,2n). Donc, comme indiqué à la figure 4c, les valeurs des signaux A,B produits ne peuvent prendre que deux valeurs (parmi 4) et s'expriment sous la forme b(n,2n) et b(n,2n+1).

Le but du décodage est donc de reproduire le bon flot des bits A,B transmis qui ont correspondu à un chemin de référence dans le treillis. On peut montrer que si des erreurs de transmission se sont produites, du fait du caractère aléatoire du bruit perturbateur et du fait que le signal transmis est convolué avec lui-même dans le registre à décalage et le circuit logique de combinaison, cette cohérence permet de retrouver des bons symboles et/ou les bons bits qui leurs ont donné naissance.

En réception, un schéma équivalent à celui de la figure 4b montre que pour un état reçu donné, il ne peut y avoir que deux états successeurs. Et ainsi de suite, un état successeur peut lui-même n'avoir que deux états successeurs. La découverte du bon cheminement dans le treillis, qui correspond aux bons bits à transmettre, conduit alors à évaluer tous les chemins possibles dans ce treillis et à choisir celui qui est le plus probable, le plus près des symboles qui ont été effectivement reçus. Si le message à transmettre comporte b bits, le nombre de chemin possible serait $2^b$ et le choix du chemin optimum nécessiterait la comparaison de $2^b$ chemins entre eux. L'algorithme de Viterbi permet de simplifier notablement l'ensemble de ces calculs.

Dans tout ce qui a précédé, on a considéré que les symboles reçus étaient binaires : des 1 ou des 0, que ces symboles soient des symboles correctement transmis ou transmis avec des erreurs. Dans la pratique, le démodulateur produit des informations analogiques alors que le décodeur de Viterbi est une unité numérique. Quand la conversion analogique numérique se produit, plutôt que d'utiliser un seuil de décision au-delà duquel on considère qu'un signal reçu est un 1 binaire ou un 0 binaire, on peut quantifier sur plusieurs bits, par exemple 5, l'expression binaire du signal analogique reçu et traiter directement les 5 bits (représentant ensemble une seule valeur de symbole) reçus pour évaluer le meilleur chemin. On effectue de cette façon une décision logicielle sur la signification des symboles reçus, ce qui améliore notablement les performances du décodeur parce qu'il est capable de faire des choix beaucoup plus fins entre les chemins. L'inconvénient en est une légère augmentation de la complexité du circuit puisqu'il faut traiter en pratique 8 bits en parallèle (ou 4, ou 16, ou autre selon la dynamique de conversion analogique numérique retenue). Dans un premier temps, on va considérer pour simplifier l'explication qu'on est cependant en présence de symboles reçus quantifiés sur un seul bit.

Pour un bit de message, deux symboles A,B ont été transmis par le canal et donc deux symboles Sa et Sb ont été reçus en sortie du démodulateur. La première opération à faire, consiste à calculer la probabilité que ces symboles soient attachés à chacune des branches possibles. Cette probabilité est définie par la distance de Hamming entre deux symboles reçus et les symboles qui sont attendus pour une branche donnée. Cette probabilité est appelée la métrique de branche. Par convention sa valeur est d'autant plus petite que la branche est plus probable. Son expression est la suivante :

Formule 1       $bm(a,b)=(Sa*a)+(Sb*b)$

Dans laquelle a et b sont les symboles attendus (pas ceux qu'on a reçu) ;
Sa,Sb sont les symboles reçus ;
bm est la métrique de branche ;
et * désigne une opération OU Exclusif.

Compte-tenu que a,b peuvent avoir chacun deux valeurs, il y a quatre métriques de branche possibles. La présence des OU Exclusifs dans l'expression de la métrique signifie que cette métrique est d'autant plus faible, donc correspond à un chemin plus probable, si les signaux reçus ressemblent aux signaux attendus. Supposons par exemple qu'on ait reçu des symboles Sa=0 et Sb=1.

On peut écrire

$$bm(0,0)=(0*0)+(1*0)=0+1=1$$

$$bm(0,1)=(0*0)+(1*1)=0+0=0$$

$$bm(1,0)=(0*1)+(1*0)=1+1=2$$

$$bm(1,1)=(0*1)+(1*1)=1+0=1$$

Naturellement, la seconde métrique bm(0,1) est la plus probable puisque sa valeur est 0. Cependant ceci n'est pas suffisant pour permettre le décodage parce que des erreurs peuvent s'être produites et avoir modifié les symboles reçus. Pour éviter ceci et exploiter la cohérence du signal ainsi que l'absence de cohérence du bruit, il est nécessaire de calculer des probabilités cumulées, c'est à dire d'évaluer les probabilités d'un chemin entier dans le treillis.

Dans ce but on va calculer des métriques de chemin. Le principe est qu'à chaque noeud est associé une métrique de chemin qui correspond à la probabilité que le noeud soit sur le chemin correct. Conformément à la représentation à la figure 4c, à chaque noeud est associé deux chemins donc deux métriques de branche pour les branches qui joignent ce noeud à deux autres noeuds. Par exemple, le noeud n est relié au noeud 2n ou au noeud 2n+1. On retiendra comme métrique de chemin, la somme minimale, par convention, des métriques de branche qui relient entre eux les noeuds situés sur ce chemin. Le calcul de la métrique de chemin comporte donc d'une part des calculs préliminaires du type : formule 2.

$$pm(n,2n) = pm(n) + bm(n,2n)$$

$$pm(n+2^{m-1},2n) = pm(n+2^{m-1}) + bm(n+2^{m-1},2n)$$

$$pm(n,2n+1) = pm(n) + bm(n,2n+1)$$

$$pm(n+2^{m-1},2n+1) = pm(n+2^{m-1}) + bm(n+2^{m-1},2n+1)$$

Les comparaisons de la première ligne à la deuxième ligne et de la troisième ligne à la quatrième ligne de cette formule, permettent de savoir parmi ces quatre métriques de chemin projetées, lesquelles deux ont une valeur minimum. On cherche ainsi à déterminer quel est le coût de transition le moins élevé pour, en partant d'un noeud donné (n ou $n+2^{m-1}$), aboutir à un de deux noeuds possibles (n ou 2n+1). On retient alors ensuite comme métrique de chemin pm(2n) et pm(2n+1) les minima de chacune de ces deux métriques de chemin projetées. A chaque cycle, on calcule donc quatre valeurs possibles de métrique de branche et on n'en retient que deux. L'opération est appelée en abrégé ACS pour Addition, Comparaison, Sélection. Elle constitue la partie essentielle de l'algorithme de Viterbi.

Le calcul de la métrique de branche s'effectue à chaque fois selon la formule 1 vue plus haut compte tenu de la valeur des symboles reçus. Le principe revient à dire, si on est à un noeud donné (0,1,2,3 sur figure 3), quelle serait la probabilité qu'on aboutisse à un noeud possible en provenance d'un noeud donné. Comme dans l'exemple il y a quatre noeuds au total, il faut calculer 8 métriques de chemin et n'en retenir que 4 à chaque fois pour conduire à la détermination du noeud dont on serait parti, compte tenu des symboles reçus, pour aboutir au noeud qu'on considère.

Le calcul de métrique de blanche peut être effectué au préalable compte tenu de la simplification évoquée plus haut. Il est représenté sur la figure 5. Ainsi, en partant d'un noeud 0,0 de valeur 0 on ne peut qu'aboutir à un autre noeud 0,0 ou à un noeud 1,0 de valeur 1. Si le noeud d'arrivé est un noeud 0,0, le symbole produit par le circuit de la figure 2 est 0,0. La branche notée bm(0,0) peut aussi être noté bm(0) en retenant une notation de 0 à 3. Par contre, si le noeud d'arrivée est le noeud 1,0, les symboles produits par le circuit de la figure 2 sont 1,1 pour consacrer la transition. Dans ce cas la branche aurait été celle correspondant à 11 c'est-à-dire 3.

Compte tenu qu'il n'y a que deux symboles A et B, qui, ensemble, ne peuvent prendre que quatre valeurs 0,1,2,3, il n'y a que quatre types de branche possibles bm(0), bm(1), bm(2) et bm(3). Conformément à ce qui a été dit plus haut, il y a quatre valeurs de métrique possibles 0,1,1,2. A chaque fois qu'un couple de symbole AB est reçu, chacune de ces branches prend une de ces quatre valeurs. On a donc, a priori, quatre métriques de branche à calculer à chaque fois.

Sur la figure 5 toutefois, on note la présence de huit branches permettant de lier les noeuds entre eux. On remarque cependant que ces branches sont identiques deux à deux, ce qui justifie le dessin de la figure 4c.

En conséquence pour chaque couple AB reçu, il y a huit branches à calculer qui sont égales entres elles deux à deux. Il est possible de calculer au préalable les métriques de branche bm(0), bm(1), bm(2), bm(3). Il est possible de les précalculer pour les quatre valeurs possibles du couple du symbole reçu Sa,Sb. Ces calculs peuvent se réaliser sous la forme d'un adressage d'une table, dont l'adresse possède quatre moments représentant respectivement le noeud qu'on considère, par exemple (n), le noeud où on est susceptible d'arriver (2n), et les valeurs Sa et Sb des symboles reçus. Si Sa et Sb sont donnés chacun sur plus que 1 bit, par exemple quantifiés sur 5 bits, la table est plus conséquente mais la solution reste la même.

En pratique pour que l'opération d'accumulation puisse se produire, or convient que les métriques de chemin, au départ, soient toutes initialisées à 0.

Après un certain nombre d'itérations, il est possible de décoder c'est-à-dire de retrouver, à posteriori, quelle était la vraie valeur du bit transmis compte tenu des symboles reçus. Pour effectuer ce décodage, en pratique on retient comme lieu de départ du décodage, le noeud pour lequel la métrique de chemin est la plus faible parmi les quatre dernièrement calculées.

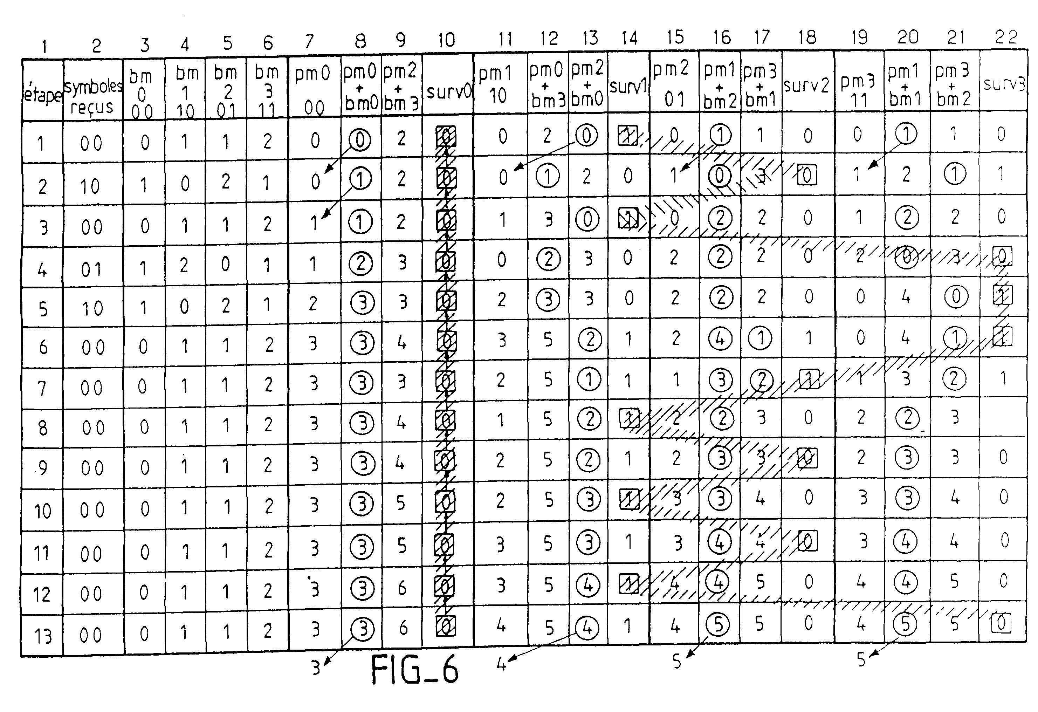

Le tableau de la figure 6 montre en détail une réalité d'un calcul effectué. Sur ce tableau, on a représenté en colonne 1 treize étapes temporelles, la treizième se produisant après la première. Dans une deuxième colonne on a représenté, à titre d'exemple, des couples de symboles reçus. On prend comme exemple que les bits du message étaient tous des 0, mais que les couples AB, qui auraient tous dus être 0,0, notamment aux étapes 2, 4 et 5, ont été différents de 00. Dans les troisième à sixième colonnes, on a indiqué les valeurs des métriques des différentes branches relatives aux symboles reçus. Dans chaque ligne, pour ces quatre colonnes, on indique quatre valeurs qui dépendent de la valeur des symboles effectivement reçus. Ainsi, pour la branche 0, qui correspond à des symboles attendus de 0,0, la métrique de branche est 0. Pour la branche 1, qui correspond à des symboles attendus de 1,0 (poids fort à droite), la métrique de branche vaut 1. Et ainsi de suite, pour la métrique de la branche 2 et la métrique de la branche 3. Les colonnes 7, 11, 15 et 19 permettent d'indiquer les métriques de chemins. On remarque qu'à l'étape 1 toutes ces métriques de chemin sont à 0.

Les colonnes 8 et 9, 12 et 13, 16 et 17 et 20 et 21 permettent de présenter les accumulations des métriques de chemin qui conduisent au noeud concerné. Le diagramme de la figure 5 montre que pour chaque couple de signaux Sa, Sb reçus, un noeud peut se convertir en deux autres noeuds attachés à deux métriques de branches. Par exemple, le noeud 0,0 peut venir du noeud 0,0 avec la métrique de branche 0,0, ou du noeud 0,1 avec la métrique de branche 1,1. S'il vient du noeud 0 sa métrique de chemin sera pm0 (ancienne valeur) plus bm0, métrique de la branche 0. S'il vient du noeud 2 sa métrique de chemin sera pm2 (ancienne valeur) plus bm3. Il y aura donc lieu d'évaluer la probabilité de venir d'un seul de ces deux noeuds, préférentiellement, en calculant la plus faible de la métrique de chemin 0 additionnée à la métrique de branche 0, ou de la métrique de chemin 2 additionnée à la métrique de branche 3.

De même le noeud 1, 1,0, peut venir du noeud 0,0 par l'intermédiaire de la métrique de branche 3 ou du noeud 2 par la métrique de branche 0. Le noeud 2, 0,1, peut venir du noeud 1 par la métrique de branche 1 ou du noeud 3 par la métrique de branche 2. Enfin, le noeud 3 peut venir du noeud 1 par la métrique de branche 2 ou rester un noeud 3 par la métrique de branche 1.

A une première étape, on calcule des métriques de branche dans les différents cas. Ensuite à chaque fois, on retient comme branche la plus probable, celle dont la valeur est la plus faible (celle dont la métrique est entourée d'un rond). Quand deux valeurs sont identiques on prend par défaut la première, celle située à gauche dans les colonnes 16 et 20 par exemple. De ce fait, à l'étape suivante, étape 2, la métrique de chemin de 0 vaut 0, de 2 vaut 0, de 1 vaut 1 et de 3 vaut 1 également.

Compte tenu des symboles reçus à la deuxième étape, en l'occurrence ici 10, on recalcule des métriques de branche bm de 0, 1, 2 ou 3. Connaissant les nouvelles valeurs des métriques de chemin, qui ont été calculé à la fin de l'étape 1, on peut calculer les métriques de chemin projetées. Par exemple, colonne 9 la métrique de chemin 2 valant 1 et la métrique de branche 3 valant également 1, la métrique de chemin projetée vaut 2. Egalement colonne 17, la métrique de chemin 3 valant 1, et la métrique de branche 2 valant 2, la métrique de chemin projetée vaut 3. Ainsi de suite, on calcule les huit métriques de chemin projetées d'où on déduit dans chaque cas les quatre métriques de chemin retenues dont la valeur de probabilité est à chaque fois la plus faible. Ainsi de suite, pour les symboles reçus de la l'étape 1 à l'étape 13, on peut calculer les métriques de chemin des différents noeuds.

Quand on effectue le choix d'une métrique de chemin parmi deux métriques de chemin projetées, cela implique la désignation d'un bit unique qui entrerait dans le circuit de la figure 2 pour provoquer l'élaboration des symboles émis et reçus. Ce bit est appelé le survivant. Pour les différents chemins, il est respectivement présenté dans les colonnes 10,14,18 et 22.

Dans l'exemple représenté, où les bits émis étaient une succession de treize 0, le survivant correspondant à une métrique de chemin de 0 serait normalement treize fois 0. Par contre, colonnes 11 à 14 ligne 1, compte tenu qu'on passe de la métrique de chemin du noeud 2 à la métrique de chemin du noeud 1 (le noeud 1 serait le plus probable), on est bien passé d'un noeud valant 0,1 à un noeud valant 1,0. Ceci signifie donc qu'on a entré un 1 dans le registre à décalage (figure 5). Il convient donc de choisir un 1 en tant que survivant numéro 2. Ainsi de suite, le tableau de la figure 6 est ainsi conçu que chaque fois qu'une des colonnes 8,12,16 ou 20 est retenue comme délivrant la métrique de chemin la probable, le survivant sera un survivant 0, il vaut un 1 dans le cas contraire quand ce sont les colonnes 9,13,17 ou 21.

Le travail exécuté est donc double, à chaque étape il consiste à calculer les huit métriques de chemin projetées et à n'en retenir que quatre, d'une part. D'autre part il consiste à déduire des quatre métriques retenues, quatre survivants. Compte tenu de la succession des symboles reçus comme indiqué sur la figure 2, le tableau de la figure 6 se déduit naturellement.

Un survivant représente le lien entre un noeud courant et son prédécesseur. Par définition, les noeuds représentent le contenu du registre à décalage.

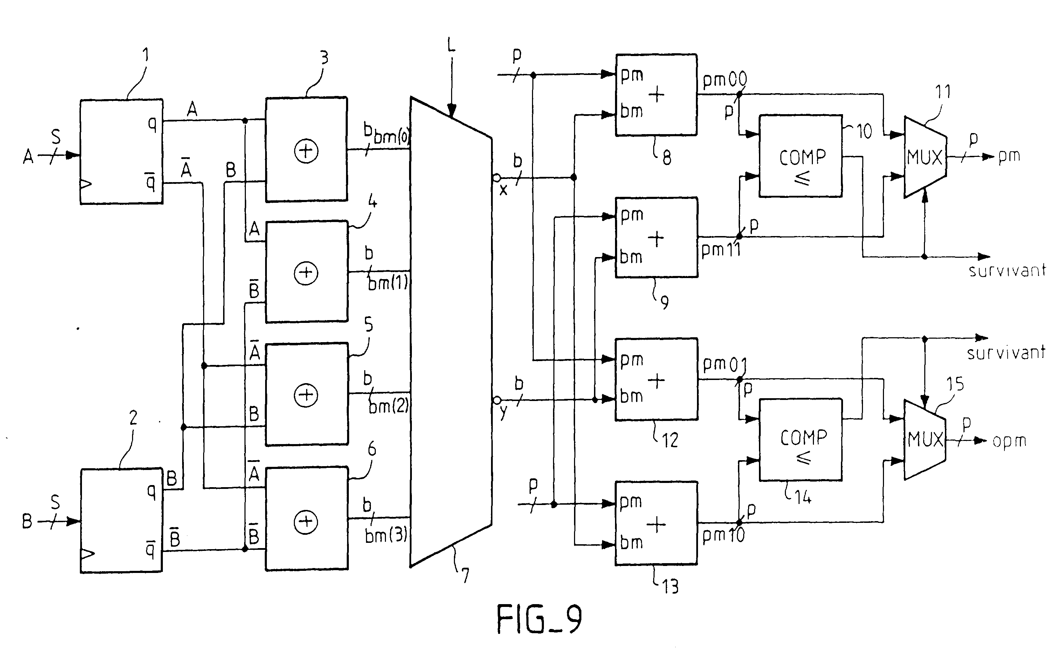

Le dépistage ou la reconstruction des bits reçus se pratique de la façon suivante. La figure 7 montre ce qui se passe d'une part lors du codage avant la transmission dans le canal et d'autre part, ce qui se passe à la réception. A l'émission, le dernier bit du mot est expulsé du registre à décalage au moment d'un décalage. A la réception, pour dépister, compte tenu de la connaissance d'un noeud r, on va pouvoir par décalage inverse en rajoutant le survivant, retrouver le noeud r-1 qui comporte ce survivant. Et ainsi de suite on peut remonter d'un noeud sur l'autre jusqu'à un noeud ancien. Ce circuit représenté est schématique. Il permet, connaissant les $2^m$ (ici m=2) métriques de chemin et les $2^m$ survivants calculés à une étape donnée, de calculer quel est le véritable survivant à l'étape précédente.

Le travail du circuit de la figure 7 peut se lire sur la figure 6. Normalement, on choisit comme noeud de départ pour le dépistage le noeud qui a globalement la métrique de chemin la plus faible. Ici, c'est le noeud 00. A l'étape 13, le fait de disposer d'un survivant 0 signifie que le noeud précédent ce noeud 00 est un noeud dans lequel le deuxième 0 (à droite) est associé au survivant qui vaut lui-même 0 ce qui donne un noeud 00 lui aussi. Ainsi de suite on remonterait les survivants entourés par des petits carrés qui sont tous des 0 dans la colonne 10.

Mais il n'est pas nécessaire, bien que utile, de partir du noeud le plus probable. Par exemple, on pourrait partir du noeud 3, valant 11 présent en colonne 19 ligne 13 pour lequel, le survivant trouvé vaut 0. Ceci signifie, que le noeud précédent serait constitué de 1,0. A l'étape 12, il faudrait donc partir d'un noeud 1,0 qui est donné en colonne 11. Pour la colonne 11, le survivant calculé, présent en colonne 14, vaut 1. Donc au coup précédent, le 1 s'en va, il reste le 0 et un 1 arrivé, on obtient un noeud 0,1 : colonne 15 pour lequel le survivant, colonne 18 vaut lui-même 0. Ainsi de suite on remonte selon le chemin grisé. Les survivants sont entourés par des petits carrés.

On constate que vers les étapes 3,2 et 1 le survivant trouvé n'est toujours pas le survivant vrai attendu. Cependant, si on effectue un départ du survivant de la colonne 18 ou du survivant de la colonne 14, on se rendrait compte que des étapes 5 aux étapes 1, le nombre des chemins de reconstruction erratiques serait limité. Il n'y en aurait qu'un à coté du bon chemin, et non pas trois. On notera par ailleurs, que c'est justement pendant les étapes 2, 4 et 5 que se sont produits les bruits de transmission puisque les symboles reçus ne sont pas 0,0 à ces étapes. Par contre, si la mémorisation des étapes avait été plus importante que 13, et avait conduit notamment à une période où le signal n'était pas trop bruité (pas trois mauvais échantillons sur quatre échantillons reçus), on se rendrait compte que tous les chemins convergeraient vers la valeur émise.

Ceci est une qualité propre du code convolutif utilisée pour le codage. Ceci montre par ailleurs l'intérêt qu'il y a à choisir un bon survivant de départ ou un bon noeud de départ. Si on ne choisi pas le bon noeud, il faut mémoriser plus longtemps pour retrouver la cohérence du signal transmis. En pratique, le temps de convergence des noeuds est borné. Quel que soit le point de départ, dans le cas présent, on peut admettre qu'au delà de 15 noeuds le résultat du dépistage des bits sera correct. On appelle longueur de troncature, le nombre de bit qu'il faut utiliser en mémorisation pour trouver à chaque fois le bon cheminement. Dans un exemple, la longueur de troncature est de environ 200.

En ce qui concerne l'égalisation de canal, on pourrait faire une démonstration du même type, sachant que la cohérence qui est apportée entre les différents symboles transmis est due aux réflexions parasites subies par le signal et qui ont toutes chances de produire des échos de la même façon d'une étape à l'autre. Tout se passe en pratique comme si on avait affaire de la même façon à une convolution, dont on ne connaît cependant pas les polynômes de départ. Pour cette raison l'égalisation de canal peut être effectuée en mettant en oeuvre l'algorithme de Viterbi.

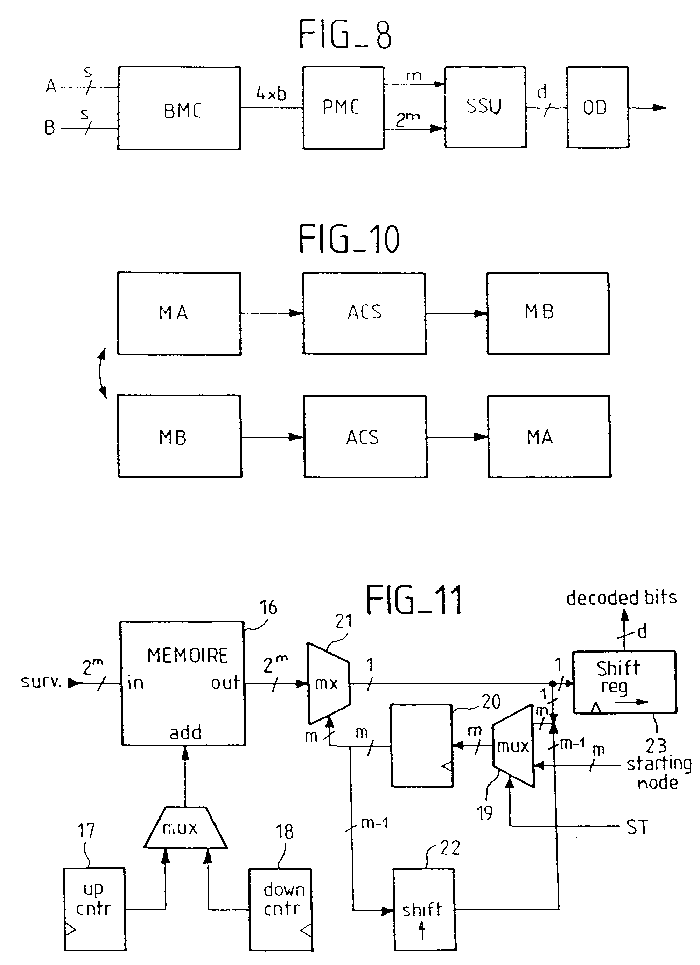

L'architecture d'un décodeur de Viterbi est représentée à la figure 8. Il comporte un premier bloc BMC qui reçoit les symboles AB quantifiés chacun sur s bits. Ce bloc effectue en pratique les calculs relatifs aux colonnes 3 à 6 de la figure 6 dans laquelle chaque colonne serait en fait quantifiée sur s+1 bits puisque les signaux Sa et Sb sont analogiques au départ.

Le bloc suivant PMC calcule les métriques de chemin et choisit parmi les métriques de chemin calculées celles qui sont les plus probables selon ce qui a été indiqué précédemment. En pratique, il calcule $2^m$ métriques de chemin et il produit $2^m$ survivants. On rappelle que si le registre à décalage comporte trois cases, m=2, il y a quatre valeurs de noeuds possibles. Par contre, si m vaut quatre, dans le cas le plus courant, il y a seize métriques de chemin à calculer et seize survivants à produire à chaque fois.

En outre, comme expliqué précédemment relativement au décryptage de la figure 6, il est préférable de partir du noeud le plus probable, le noeud 0,0 de la colonne 7, pour converger plus rapidement vers le bon résultat. Le bloc PMC produit donc trois types différents de signaux : les $2^m$ métriques de chemin et les $2^m$ survivants associés, ainsi que la désignation du noeud de départ.

Un bloc suivant SSU enregistre les survivants et effectue la mise à jour pour calculer les bits décodés. Le bloc SSU met essentiellement en oeuvre le circuit représenté sur la figure 7. Il ne le fait cependant que pour les survivants qui correspondent à la métrique de chemin la plus faible. Donc le circuit SSU stocke des données équivalent au tableau de la figure 6 et effectue le travail du circuit de la figure 7.

Un dernier bloc OD remet en forme les bits traités. On verra plus loin comment.

La figure 9 montre de manière schématique un moyen de réalisation des blocs BMC et PMC. La partie gauche de la figure 9 montre la production des métriques de branche. Les deux signaux A B numériques sont introduits dans des bascules de types D, 1 et 2 respectivement, qui produisent chacune à leur sortie q /q des signaux A /A, et B /B respectivement. Dans un premier additionneur 3, on additionne les signaux A et B de manière à produire la métrique de branche 0. En effet, en application de la formule 1 vue plus haut, si les symboles a et b attendus valent 0,0 (bm(0)), la formule précédente donne Sa+Sb puisque chacun de ces signaux doit être composé dans un OU Exclusif dont l'autre entrée est 0, c'est à dire dont la sortie est identique au signal entré. Un même type d'explication permet d'expliquer que les additionneurs 4, 5 et 6 qui reçoivent les signaux respectivement A /B, /A B, /A /B, produisent des signaux bm(1), bm(2), bm(3). Alors que pour la quantification, les signaux A et B sont codés sur s bits, les signaux disponibles en sortie des additionneurs 3 à 6 sont codés sur s+l bits du fait de l'addition. Les additionneurs 3 à 6 sont des additionneurs à s bits.

Les métriques de branche ainsi calculées sont ensuite introduites, selon l'invention, dans un multiplexeur 7 dont le fonctionnement sera expliqué plus loin. La partie à droite du multiplexeur 7 du circuit de la figure 9 est utilisée pour effectuer les fonctions du bloc PMC. Dans l'exemple représenté, ce circuit PMC comporte deux paires d'additionneurs, une première paire d'additionneurs comporte les additionneurs 8 et 9, l'autre les additionneurs 12 et 13. Les additionneurs 8 et 9 sont par exemple chargés d'exécuter les additions indiquées dans les colonnes 8 et 9 de la figure 6, alors que les additionneurs 12 et 13 vont être chargés d'effectuer les additions indiquées dans les colonnes 12 et 13 de la figure 6. Dans ce but, par exemple l'additionneur 8 recevra un signal représentatif de l'ancienne métrique de chemin quantifié sur p bits sur une entrée pm. Sur sa deuxième entrée bm l'additionneurs 8 recevra la métrique de branche, quantifié sur b bits et provenant du multiplexeur 7. L'additionneur 8 délivre en sortie une métrique projetée correspondant en pratique au noeud 00. Dans les même conditions, l'additionneur 9 reçoit l'ancienne métrique de chemin 2 et la métrique de branche 3 délivrée par le multiplexeur 7. Il produit une métrique de chemin qui correspondrait au noeud 1,0.

Les deux métriques produites par les additionneurs 8 et 9 sont comparées dans un comparateur 10 qui choisit la métrique dont la valeur est la plus faible par convention. Par exemple, figure 6 première ligne, le comparateur 10 effectue le travail représenté par la flèche qui désigne le noeud retenu. Le comparateur 10 produit en pratique un signal sur 1 bit qui vaut 0 ou 1 selon le noeud retenu. Le signal délivré par le comparateur 10 est introduit à l'entrée d'un multiplexeur 11 qui sélectionne à titre de prochaine métrique celle qui correspond au minimum détectée. En l'occurrence dans le cas présent, si le signal sorti du comparateur vaut 0, la métrique de chemin retenue est la métrique du noeud 00 ; si elle vaut 1 on retiendra la métrique du noeud 10. La métrique de chemin retenue est enregistrée dans la mémoire par l'intermédiaire du circuit SSU.

L'avantage de cette structure se situe dans le fait que le signal de commande du multiplexeur sert en même temps de définition du survivant pour l'étape considérée. Celui-ci est également mémorisé dans le circuit SSU.

En même temps que les circuits 8 à 11 effectuent l'opération de type ACS relative aux colonnes 7 à 10 de la figure 6, des circuits comparables 12 à 15 effectuent l'opération de type ACS pour les colonnes 11 à 14. En effet on a constaté, figure 6, que pour effectuer ces calculs on a seulement besoin des deux métriques de chemin pm0, pm2, et des deux métriques de branches bm0 et bm3. Dans une étape suivante, avec le multiplexeur 7, on va mettre à disposition du bloc PMC les autres métriques de branche bml et bm2 en même temps que les autres métriques de chemin pml et pm3. De ce fait, en deux opérations, si elles sont suffisamment rapides, on peut effectuer tout le travail représenté par une ligne de la figure 6.

Ces deux opérations sont rythmées par un ordre L appliqué sur le multiplexeur 7 ainsi que sur d'autres organes qu'on étudiera plus loin. On pourrait néanmoins procéder différemment, soit n'avoir qu'un seul circuit de type ACS, et le faire travailler autant de fois qu'il y a de noeuds possibles (4 noeuds pour m=2, 16 noeuds pour m=4 comme dans le cas préféré) soit, au contraire augmenter le nombre des circuits de type ACS.

Pour tenir compte du fait qu'à tout moment on doit connaître les métriques de chemin anciennes et les métriques de chemin nouvelles, on peut utiliser, conformément à la figure 10, un circuit avec deux mémoires : une mémoire MA et une mémoire MB. Dans une première étape, on considère que les métriques de chemin anciennes sont stockées dans la mémoires MA. On se sert de son contenu d'information pour l'injecter dans le circuit général du type ACS qui calcule les nouvelles métriques de chemin. Les nouvelles métriques de chemin sont, à ce moment là, rangées dans une autre mémoire MB, pour une étape suivante. Pour une ligne suivante du diagramme de la figure 6, on inverse tout simplement les rôles de ces mémoires, la mémoire MB devenant pourvoyeuse d'informations pour les métriques de chemin anciennes, la mémoire MA servant alors à enregistrer les métriques de chemin nouvelles.

Le schéma de principe du circuit SSU est montré sur la figure 11. Excepté quand le débit des informations est élevé, ce bloc est basé sur une mémoire : la mémoire 16. Cette mémoire est gérée comme une mémoire circulaire. La procédure de dépistage est effectuée chaque d cycles. De cette manière, à chaque d cycles, on décode d bits. Aussi, durant d cycles, correspondant en pratique à d lignes sur la figure 6, il est nécessaire d'effectuer d écritures pour stocker les survivants provenant des circuits ACS. De même, pendant la durée totale de ces d cycles, il est nécessaire d'effectuer la lecture, par exemple selon un des cheminements grisés sur la figure 6, de LT+d survivants. On est donc amené à effectuer LT+d cycles de lecture de la mémoire. LT est un nombre entier qui correspond à la longueur de troncature : c'est en résumé le nombre de survivants, depuis le dernier survivant extrait, qu'il faut écarter avant de considérer que l'algorithme est convergent et que les bits qui précèdent correspondent aux vrais bits émis.

Pour simplifier, en admettant que la longueur de troncature sur la figure 6 est de huit, on ne pourrait considérer comme valables dans cette figure que les 13-8 = 5 premiers bits.

Compte-tenu qu'au-delà de la longueur de troncature tous les bits sont réputés correspondre aux vrais bits émis, plus la mémoire est grande, plus le nombre de bon bits à extraire est élevé. Cependant, pour des raisons de débit, on ne peut pas non plus attendre indéfiniment avant de commencer à décoder. Il y a donc un compromis à mettre en oeuvre. L'exemple traité jusqu'ici est approximatif des proportions auxquelles il faut se livrer.

La mémoire tournante 16 de la figure 10, est donc adressée en écriture, à chaque temps de cycle, à une adresse produite par un compteur 17 croissant synchronisé avec l'horloge des étapes. Par contre la lecture doit être exécutée, dans le sens décroissant (de la ligne 13 à la ligne 1) avec un décompteur 18 dont le point de départ est fixé, tous les d cycles, par la valeur du compteur 17. Compte tenu de ce que pendant d cycles on écrit d métriques et qu'on en lit LT+d, le débit d'information doit être faible par rapport à la vitesse de la mémoire de façon à y arriver.

Le circuit de la figure 11 comporte un multiplexeur 19 qui est déclenché par un signal impulsionnel ST de début de dépistage (produit tous les d cycles). Ce multiplexeur 19 reçoit en permanence le noeud de départ, c'est-à-dire celui qui correspond à la métrique de chemin la plus faible. Par exemple, figure 6 ligne 13, la métrique de chemin la plus faible vaut 3, elle correspond à un noeud de départ 00. Ce noeud de départ, codé sur m bits, est transmis au début du dépistage par l'intermédiaire d'un registre 20 à un multiplexeur 21 branché en sortie de la mémoire 16. Le multiplexeur 21 reçoit, pour chaque étape (par exemple l'étape 13), les 4 survivants extraits. Compte tenu de la commande de multiplexage qui lui est appliqué et qui est égale au noeud de départ, il sélectionne un des quatre survivants. Ce survivant est codé sur un 1 bit. Ce survivant sélectionné est stocké dans un registre 23.

L'opération évoquée préalablement (figure 7) pour déterminer, in fine, le noeud origine du noeud de départ consiste à mettre le noeud de départ, disponible en sortie au registre 20 dans un registre à décalage 22, à perdre le premier bit de ce registre et à le remplacer, à la fin, par le survivant disponible à la sortie du multiplexeur 21. Ce nouveau noeud est alors transmis au multiplexeur 19 qui le laisse passer en direction des registres 20 et 22 où ce nouveau noeud prend la place du noeud de départ avec lequel on a commencé.

Et le cycle continue, conduisant à disposer en sortie des registres 20 et 22, petit à petit tous les LT+d noeuds. En même temps, les survivants sont stockés dans le registre 23 à décalage. Le registre 23 peut être un registre à d cases seulement compte tenu que seulement les d plus anciens survivants, se trouvant au-delà des LT survivants extrais, sont intéressants. Les bits décodés sont disponibles sur les sorties du registre 22.

On retiendra cependant que le bit le plus ancien, par exemple celui correspondant à l'étape 1 de la figure 6, se trouve à la première case du registre, près de son entrée alors que le bit le plus récent, par exemple celui de la ligne 5 de la figure 6 se trouve à la dernière case du registre 23. Le circuit OD de la figure 8 ne fait que remettre dans l'ordre ces bits extraits.

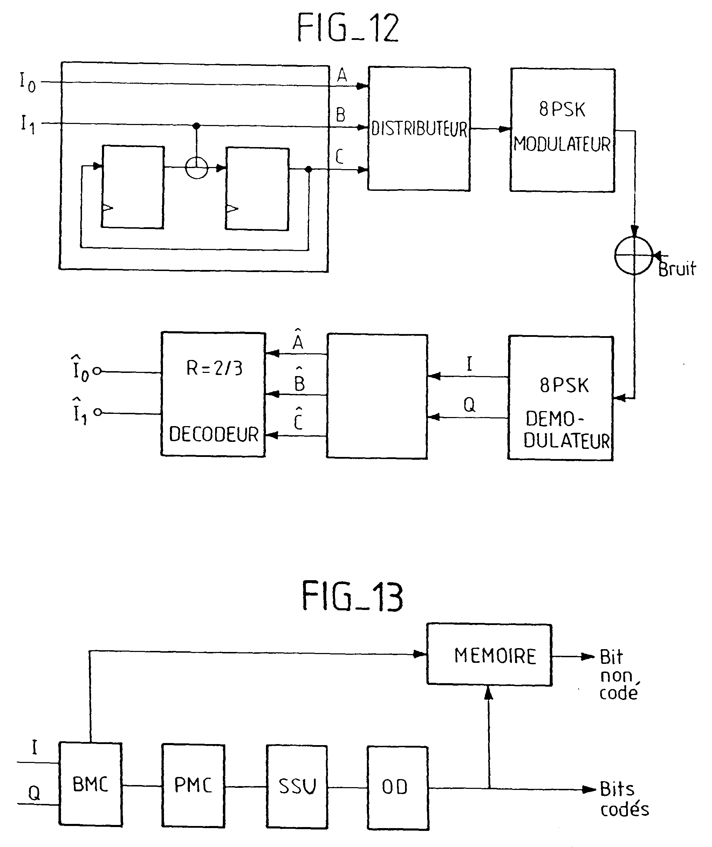

La figure 12 montre un système de modulation codé en treillis. Il comporte un codeur convolutif à taux R=2/3 puisqu'il reçoit deux signaux I0 et I1 et qu'il en produit trois A B C. Ce codeur est relié à un modulateur de type 8PSK par l'intermédiaire d'un distributeur. Les trois symboles A B C produisent, par l'intermédiaire du distributeur, des décalages de phase de la porteuse. Le rôle du distributeur est de produire une correspondance entre les symboles et les décalages de phase qui utilise un code de Gray. Deux phases proches correspondent à deux symboles qui diffèrent l'un de l'autre par seulement 1 bit. De ce fait une erreur de phase correspond à une erreur de bit. Le démodulateur produit un signal de phase I et un signal en quadrature de phase Q. Un détecteur relié au démodulateur estime les trois symboles reçus ABC qui seront utilisés dans le décodeur de Viterbi pour retrouver les deux bits I1 et I0 émis.

Dans la constellation de codage proposée par la modulation 8 PSK, on peut distinguer deux sous-ensembles de points. Ces sous-ensembles sont choisis de telle façon que la distance entre les deux sous-ensembles soit petite, alors que la distance entre les points d'un sous-ensemble est grande. Le but de la modulation codée en treillis est d'augmenter artificiellement l'immunité au bruit en utilisant un codeur convolutif pour protéger les symboles produits par le distributeur. La distance entre deux sous-ensembles est petite mais les bits qui permettent le choix entre ces sous-ensembles sont protégés par un code de redondance. Par exemple, les bits codés B et C permettent de choisir le sous-ensemble alors que le bit A, qui est transmis tel quel, permet de choisir le point dans le sous-ensemble. En pratique le décodeur de Viterbi peut être capable d'effectuer la détection et le décodage lui-même.

Dans un tel cas, le circuit de calcul de métrique de branche du décodeur de Viterbi doit produire les métriques de branches en calculant la distance euclidienne entre les données reçues et tous les points possibles dans tous les sous-ensembles de constellations. Le circuit garde dans ce but en mémoire, sans traitement, le point le plus proche (qui correspond aux bits non codés) pour chaque sous-ensemble. Le choix du sous-ensemble (déterminé par les bits codés) est effectué par l'algorithme de Viterbi classique. Une fois que le sous-ensemble a été choisi et que les bits codés ont été recouvrés, il est possible de recouvrer le bit non codé. Le schéma équivalent de ce décodage est représenté à la figure 13.

Compte tenu de ce que le calcul de la métrique de branche n'est pas fait par des simples additions comme ce qui a été vu précédemment mais qu'on mesure une distance euclidienne, les calculs sont de préférence tabulés et on accédera à la valeur calculée par adressage d'une table. En outre dans le cas présent, une mémoire est utilisée pour garder la trace du bit non codé. Ce bit non codé est choisi en fonction de la valeur des bits codés reçus. La mémoire reçoit donc les bits non codés, non traités à partir du circuit BMC, et elle ne stocke seulement que celui qui correspond aux bits codés.

Pour l'égalisation on peut également montrer une utilisation de l'Algorithme de Viterbi. La principale différence de cette utilisation avec celle correspondant au codage convolutif se situe dans le fait que les polynômes générateurs équivalents ont ici des valeurs réelles dépendant de la réponse impulsionnelle du canal de transmission.

Comme d'habitude dans ce cas, l'algorithme de Viterbi est utilisé pour évaluer, à chaque noeud, quel est celui qui donne la distance euclidienne cumulée minimale entre le noeud attendu et un noeud testé pour les données effectivement reçues. Ce noeud est ensuite utilisé pour effectuer le dépistage de la séquence transmise. Après de nombreuses simplifications on peut dire que dans un tel cas, la métrique de branche est du type $\alpha + \beta \, y_k$. Dans cette expression $\alpha$ et $\beta$ peuvent être calculés avant la réception des échantillons $y_k$.

Dans l'invention on a mis en évidence que la mise en oeuvre de l'algorithme de Viterbi dans les trois exemples présentés est identique. La seule différence résulte de la manière dont on calcule les métriques de branches. Si ce calcul est tabulé, la seule différence repose sur le contenu des tables. Dans l'état de la technique toutes les opérations de décodage qui ont été décrites jusqu'à présent sont effectuées sous forme logicielle au moyen d'un processeur de traitement mettant en oeuvre un algorithme de Viterbi : à chaque pas de calcul le processeur charge un code instruction, traite la donnée, effectue le transfert. Un tel processeur est par exemple décrit dans le document US A 5 220 570. Un premier problème se pose pour l'exécution de toutes ces itérations en temps réel quand le débit d'information est élevé. Ainsi, avec un processeur de traitement signal de type classique comme le ST 18950 de SGS THOMSON MICROELECTRONICS, il a été évalué que le nombre de cycles de travail nécessaires au traitement d'un échantillon de décodage convolutif est de 208. Ce nombre de cycles est de 179 quand il s'agit d'égalisation. Le nombre de cycles nécessaire au traitement de l'égalisation et du décodage est donc trop important.

En outre, même si on veut réaliser un circuit intégré spécifique ultra rapide pour effectuer ces traitements en temps réel, on va se heurter à une difficulté supplémentaire qui est liée à la diversité des modes de codage possibles dont on a donné quelques exemples jusqu'ici. En effet, si on établit l'architecture d'un processeur ultra rapide, demandant donc beaucoup d'efforts pour sa mise au point, alors que le circuit réalisé ne va pas pouvoir servir que dans un très petit nombre de cas, il est impossible d'atteindre la rentabilité requise.

Dans l'invention on a remarqué que la partie la plus cruciale du traitement concernait les opérations de types A C S. En ce qui concerne les calculs de métrique de branche on a vu qu'on pouvait y accéder par des lectures de table. Dans l'invention on a alors eu comme idée de réaliser, en périphérie d'un processeur de type classique, un circuit spécialisé qu'on appellera un co-processeur et réalisant la fonction A C S présentée jusqu'ici. On notera de ce point de vue que le schéma représenté sur la figure 9, partie à droite du multiplexeur 7, n'est pas connu dans l'état de la technique. Il n'a été présenté ici que pour permettre une explication aisée de cette invention complexe. En pratique, il n'est connu que l'exécution de la fonction présentée de la partie droite de cette figure 9. Par contre sa représentation sous forme d'un circuit, et la décision de réaliser un tel circuit en périphérie d'un circuit intégré d'un processeur donnée est nouvelle. Ceci signifie qu'un même circuit intégré comportera le processeur, connu, et le co-processeur de l'invention.

En outre, une caractéristique du circuit de l'invention concernera l'adressage. Celui-ci a pour objet un agencement de la mémoire, des pointeurs, et des index qui est optimal. De même il permet un séquencement du traitement en un minimum de cycles. La structure ajoutée est elle même minimale, et dans un perfectionnement on verra comment on code les opérations du co-processeur avec le minimum de bits. Dans un perfectionnement le processeur utilisé possède deux bus X et Y associés chacun à une mémoire. Il est alors possible de faire deux accès par cycle.

D'une manière interne dans le co-processeur il faut pouvoir faire, pour l'égalisation, la lecture de deux métriques et de deux probabilités ainsi que le calcul et l'écriture de deux métriques. Pour le décodage il faut faire la lecture de deux métriques et l'écriture de deux métriques. Dans ce cas le nombre minimal de cycles est de trois pour l'égalisation et de deux pour le décodage. Le cas le plus contraignant est donc le cas de l'égalisation.

Dans l'invention, on réalise un circuit intégré comportant un processeur et un co-processeur. Le co-processeur est spécialisé pour effectuer les opérations d'accumulation comparaison et sélection (ACS) afin de limiter le travail d'un processeur qui aurait à les effectuer. On montrera qu'en choisissant judicieusement la structure du co-processeur on peut rendre ce co-processeur suffisamment programmable pour convenir à de très nombreuses situations de mise en oeuvre de l'algorithme de Viterbi.

L'invention concerne donc un circuit de traitement de signal comportant un processeur de traitement, une mémoire programme pour stocker des instructions d'un programme de traitement, ce programme de traitement comportant des moyens de mise en oeuvre d'un algorithme de Viterbi, une mémoire de données pour stocker des données reçues et des données traitées par ce circuit, ces données étant représentatives de métriques de chemin, un co-processeur en relation avec ces mémoires pour effectuer un traitement d'accumulation-comparaison-sélection correspondant à cet algorithme caractérisé en ce que le co-processeur comporte en entrée

- un jeu de registres de stockage de ces données dont les entrées et sorties sont reliées à des multiplexeurs pour faire effectuer au co-processeur plusieurs traitements d'accumulation comparaison sélection à l'occasion de chaque accès mémoire.

L'invention sera mieux comprise à la lecture du complément de description qui suit et à l'examen des figures qui l'accompagnent. Celles-ci ne sont données qu'à titre indicatif et nullement limitatif de l'invention. Les figures montrent:

Figures 1 à 13: des diagrammes déjà commentés montrant le domaine d'application de l'invention, un mode connu de traitement des données, et des représentations schématiques de fonctions de traitement de signal mises en oeuvre dans l'invention;
Figure 14: une représentation d'architecture préférée de réalisation du co-processeur de l'invention dans le cas d'un décodeur et d'un égaliseur.

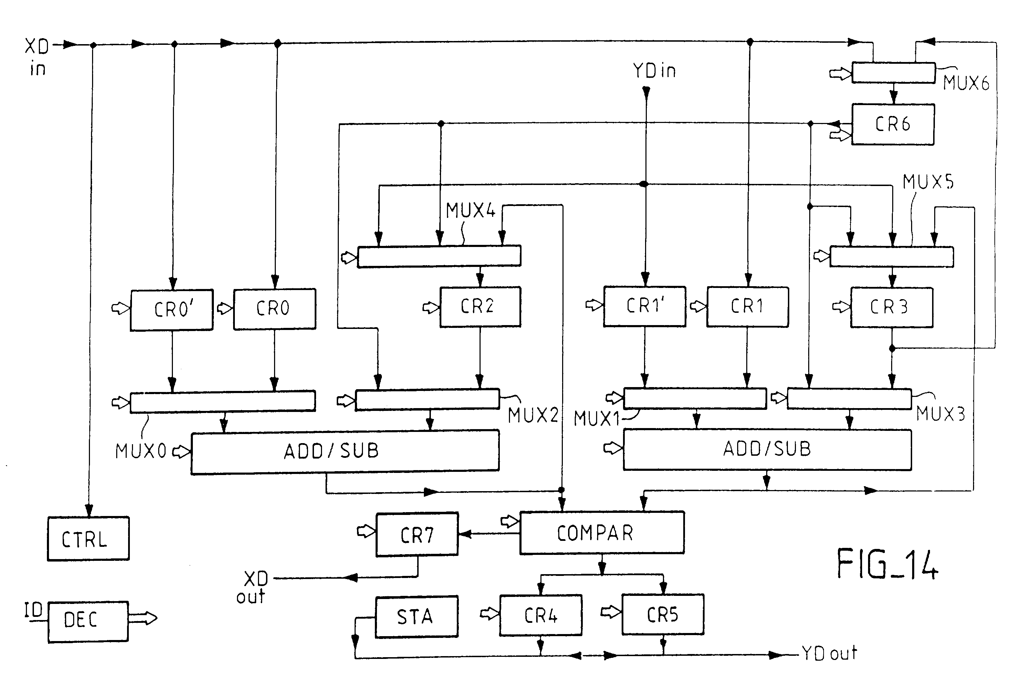

La figure 14 montre l'architecture du co-processeur. Le processeur réalisé sur le même circuit intégré n'est pas montré. Ce processeur gère les accès au co-processeur et les signaux de commande de ce co-processeur d'une manière classique. Ce co-processeur comporte deux bus de données XD et YD. Ces bus sont reliés d'une part aux mémoires MA et MB vues précédemment et gérées par le processeur. Les mémoires MA et MB peuvent aussi être regroupées en une seule mémoire possédant un accès double. Ces bus sont commutés, d'un traitement à un autre, respectivement de la mémoire MA à la mémoire MB et de la mémoire MB à la mémoire MA puis inversement. Pour un traitement donné, on considérera que le bus XD est relié à la mémoire MA qui contient, à un moment du traitement, les métriques anciennes. Le bus XD est relié à deux registres tampons, CR0 et CR1, qui servent à prélever sur le bus XD les métriques anciennes lues dans la mémoire MA et à les présenter à des entrées de deux additionneurs soustracteurs ADD/SUB. Ces additionneurs soustracteurs correspondent aux additionneurs 8 et 9 de la figure 9. On a pu montrer par ailleurs qu'un double circuit de type ACS, comme celui montré sur la figure 9 avec les additionneurs 8, 9, 12 et 13, n'était en pratique pas plus rapide qu'un circuit simple (puisque ce sont les accès par les bus qui limitent la performance du co-processeur) mais qu'il était par contre bien plus compliqué. La sortie du circuit de la figure 14 est connectée au bus YD qui, pour le traitement en cours, est relié à la mémoire MB.

Les échantillons reçus sont, après calcul des métriques de branches, stockés au fur et mesure de leur réception dans une ou l'autre des mémoires MA ou MB. Dans le traitement présent les métriques de branches sont stockées dans la mémoire MB et sont transportées par le bus YD dans des registres CR2 et CR3 connectés à d'autres entrées des additionneurs soustracteurs ADD/SUB. Les sorties des deux additionneurs soustracteurs ADD/SUB sont reliées aux deux entrées d'un comparateur COMPAR qui effectue le traitement du circuit 10 de la figure 9. Le comparateur COMPAR a donc une sortie reliée à deux registres tampons CR4 et CR5 qui mémorisent les valeurs de métriques de chemin retenues et qui les délivrent sur le bus YD.

Si on appelle bm les valeurs des métriques de branches, celles ci peuvent s'exprimer (en application de la formule 1 vue ci-dessus) sous la forme:

$$bm1 = Sa + Sb$$

$$bm2 = Sa - Sb$$

$$-bm2 = -Sa + Sb$$

$$-bm1 = -Sa - Sb$$

Dans cette expression Sa et Sb représentent les échantillons reçus. Ces valeurs bm peuvent se ramener à deux valeurs en jouant sur les signes.

Le séquencement des calculs de métriques peut alors se généraliser, dans le cas préféré ou m=4 et où il faut calculer 16 métriques, de la manière suivante:

1ère itération pm(0)-bm1 , pm(1)+bm1 $\rightarrow$ pm(0)
    pm(0)+bm1 , pm(1)-bm1 $\rightarrow$ pm(8)
2ème itération pm(2)+bm1 , pm(3)-bm1 $\rightarrow$ pm(1)
    pm(2)-bm1 , pm(3)+bm1 $\rightarrow$ pm(9)
3ème itération pm(4)-bm2 , pm(5)+bm2 $\rightarrow$ pm(2)
    pm(4)+bm2 , pm(5)-bm2 $\rightarrow$ pm(10)
4ème itération pm(6)+bm2 , pm(7)-bm2 $\rightarrow$ pm(3)
    pm(6)-bm2 , pm(7)+bm2 $\rightarrow$ pm(11)
5ème itération pm(8)-bm1 , pm(9)+bm1 $\rightarrow$ pm(4)
    pm(8)+bm1 , pm(9)-bm1 $\rightarrow$ pm(12)
6ème itération pm(10)+bm1 , pm(11)-bm1 $\rightarrow$ pm(5)
    pm(10)-bm1 , pm(11)+bm1 $\rightarrow$ pm(13)
7ème itération pm(12)-bm2 , pm(13)+bm2 $\rightarrow$ pm(6)
    pm(12)+bm2 , pm(13)-bm2 $\rightarrow$ pm(14)
8ème itération pm(14)+bm2 , pm(15)-bm2 $\rightarrow$ pm(7)
    pm(14)-bm2 , pm(15)+bm2 $\rightarrow$ pm(15)

On constate qu'il n'y a ici que 8 itérations (alors qu'il y a en fait 16 calculs à faire) parce qu'au cours d'une même itération on calcule deux valeurs nouvelles de métriques pm(i) et pm(i+8). On calcule les pm(i) et pm(i+8) en ne faisant que commuter à l'entrée des additionneurs ADD/SUB les signes de bml et bm2. Au moment de cette commutation on stocke le résultat dans un registre CR4 ou dans un autre CR5 selon le cas. De plus cette commutation n'est exécutée qu'une fois sur deux de telle façon à alterner avec le chargement dans les registres des métriques anciennes pm(i) et pm(i+1). Ainsi à chaque pas de calcul, soit on commute les signes de bml et bm2 et la connexion de raccordement des registres CR4 ou CR5, soit on charge d'autres anciennes métriques.

Par ailleurs le comparateur COMPAR délivre aussi en sortie dans un registre CR7 connecté au bus XD le survivant détecté. Ce faisant le circuit COMPAR de la figure 14 joue le rôle des circuits 10 et 11 de la figure 9.

De façon à donner une plus grande souplesse au circuit de la figure 14, dans l'invention, les registres CR0 à CR3 ne sont pas connectés directement aux entrées des additionneurs soustracteurs ADD/SUB. Ils leurs sont reliés par l'intermédiaire de multiplexeurs respectivement MUXO à MUX3. Ces quatre multiplexeurs permettent de présenter aux additionneurs soustracteurs ADD/SUB, respectivement, soit des corrections stockées dans des registres CR0' ou CR1' en provenance des bus XD ou YD respectivement, au lieu des métriques anciennes stockées dans les registres CR0 ou CR1, soit un échantillon SD stocké dans un registre CR6 en relation avec le bus XD (au moment du traitement) et avec ces multiplexeurs MUX2 et MUX3 au lieu des métriques de branches stockées dans les registres CR2 ou CR3. Les corrections dont il s'agit concernent les échos du canal de transmission et des valeurs de quantification qui peuvent être précalculées en correspondance (notamment dans des tables) et servir à déterminer la "vraie" valeur d'un échantillon, compte tenu des valeurs qu'on a retenues pour des échantillons précédents dont les échos viennent perturber la signification de l'échantillon reçu. En pratique on va par exemple utiliser l'additionneur soustracteur de droite pour soustraire (ou additionner) l'échantillon reçu à ces corrections d'écho dans un premier temps. Le résultat sera stocké dans le registre CR3 dans un premier temps puis dans le registre CR6, et le contenu de ce registre CR6 sera ensuite représenté par les multiplexeurs MUX2 ou MUX3 quand nécessaire.

Pour rendre ces transferts de données facilement commandables par le processeur qui va gouverner le co-processeur, les registres CR2, CR3 et CR6 sont reliés en entrée à la sortie de multiplexeurs respectivement MUX4 MUX5 et MUX6. Les multiplexeurs MUX4 et MUX5 sont reliés en entrée au bus YD, au registre CR6 et, respectivement, aux sorties de leur additionneur soustracteur respectifs. Le multiplexeur MUX6 est relié en entrée au bus XD et à la sortie du registre CR3.

Le co-processeur comporte d'une manière habituelle des registres de contrôle CTRL et d'état STA connectés respectivement aux bus XD et YD. Par ailleurs, un décodeur d'instructions DEC reçoit du processeur, par l'intermédiaire d'un bus d'instructions ID, des ordres à destination des circuits du co-processeur. Ce décodeur DEC délivre alors à chaque accès aux mémoires MA et MB une séquence des ordres utiles aux déclenchements des registres, des multiplexeurs, des additionneurs soustracteurs et du comparateur. Le fonctionnement de ces déclenchements n'a rien de particulier dans l'invention et ne justifie pas une description spécifique. On notera toutefois que, du fait du caractère alternatif du fonctionnement de ces registres, multiplexeurs, additionneurs soustracteurs et comparateur le nombre de bits nécessaires pour les commander tous, malgré la variété des situations, est limité. Sept bits suffisent en pratique.

## Revendications

1. Circuit de traitement de signal comportant un processeur de traitement, une mémoire programme pour stocker des instructions d'un programme de traitement, ce programme de traitement comportant des moyens de mise en oeuvre d'un algorithme de Viterbi, une mémoire de données pour stocker des données reçues et des données traitées par ce circuit, ces données étant représentatives de métriques de chemin, un co-processeur en relation avec ces mémoires pour effectuer un traitement d'accumulation - comparaison - sélection correspondant à cet algorithme caractérisé en ce que le co-processeur comporte en entrée

   - un jeu de registres (CR2, CR3, CR6) de stockage de ces données dont les entrées et sorties sont reliées à des multiplexeurs (MUX1-MUX6) pour faire effectuer au co-processeur plusieurs traitements d'accumulation comparaison sélection à l'occasion de chaque accès mémoire.

2. Circuit selon la revendication 1, caractérisé en ce que ce le co-processeur ne comporte qu'un circuit du type ACS pour effectuer deux additions simultanément, comparer les résultats de ces deux additions, et en sélectionner un.

3. Circuit selon l'une des revendications 1 à 2, caractérisé en ce que ce le co-processeur comporte

   - des additionneurs de type additionneur soustracteur commutables pour limiter le temps des calculs itératifs entrepris par ce co-processeur.

4. Circuit selon l'une des revendications 1 à 3, caractérisé en ce que le co-processeur comporte

   - deux bus pour pouvoir être alternativement en relation en lecture puis en écriture avec deux mémoires, et en ce que le processeur comporte un circuit pour alterner les connexions du co-processeur à chacun de ces bus.

## Patentansprüche

1. Schaltkreis zur Signalverarbeitung mit einem Verarbeitungsprozessor, einem Programmspeicher zum Speichern der Befehle eines Verarbeitungsprogramms, wobei dieses Verarbeitungsprogramm Schritte zum Durchführen eines ViterbiAlgorithmus umfaßt, einem Datenspeicher zum Speichern der empfangenen Daten und der durch den Schaltkreis bearbeiteten Daten, wobei die Daten die Wegmetrik wiedergeben, einem Coprozessor, der mit den Speichern zum Abarbeiten von Akkumulation-Vergleich-Auswahl gemäß dem Algorithmus verbunden ist, dadurch gekennzeichnet, daß der Coprozessor am Eingang umfaßt:

   - einen Registersatz (CR2, CR3, CR6) zum Speichern der Daten, deren Eingänge und Ausgänge mit Multiplexern (MUX1-MUX6) verbunden sind, so daß der Coprozessor mehrfach Akkumulation-Vergleich-Auswahl anläßlich jedes Zugriffs auf den Speicher ausführt.

2. Schaltkreis nach Anspruch 1, dadurch gekennzeichnet, daß der Coprozessor nur einen Schaltkreis vom Typ ACS umfaßt, um zwei Additionen simultan auszuführen, die Ergebnisse der beiden Additionen zu vergleichen und eines auszuwählen.

3. Schaltkreis nach einem der Ansprüche 1 und 2, dadurch gekennzeichnet, daß der Coprozessor umfaßt:

   - Addierer vom auf Addierer/Subtrahierer umstellbaren Typ, um die Zeiten der iterativen Berechnungen durch den Coprozessor zu limitieren.

4. Schaltkreis nach einem der Ansprüche 1 bis 3, dadurch gekennzeichnet, daß der Coprozessor umfaßt:

   - zwei Bussysteme, so daß er alternativ beim Lesen und dann beim Schreiben mit zwei Speichern verbunden werden kann, und dadurch, daß der Prozessor einen Schaltkreis umfaßt zum Umschalten der Verbindungen des Coprozessors mit jedem dieser Bussysteme.

## Claims

1. Signal processing circuit including a processing processor, a program memory for storing the instructions of a processing program, this processing program including means of using a Viterbi algorithm, a data memory for storing data received and data processed by this circuit, these data representing path metrics, a coprocessor associated with these memories to perform accumulation/comparison/selection processing corresponding to this algorithm, characterised in that the coprocessor has at its input

- a set of registers (CR2, CR3, CR6) for storing these data, whose inputs and outputs are connected to multiplexers (MUX1-MUX6) to cause the coprocessor to perform a number of accumulation comparison selection processing operations each time the memory is accessed.

2. Circuit according to Claim 1, characterised in that the coprocessor includes only one ACS-type circuit to perform two additions simultaneously, compare the results of these two additions and select one of them.

3. Circuit according to one of Claims 1 to 2, characterised in that the coprocessor includes

- adders of the switchable adder subtracter type for limiting the time required by this coprocessor for performing iterative calculations.

4. Circuit according to one of Claims 1 to 3, characterised in that the coprocessor includes

- two buses in order to be able to be alternately in a reading then in a writing relationship with two memories, and in that the processor includes a circuit for alternating the connections of the coprocessor to each of these buses.

## FIG_1

SOURCE → CODEUR DE SOURCE → CODEUR DE CANAL → MODULA-TEUR → CANAL DE TRANS-MISSION ← Bruit

UNITE DE TRANSMISSION

UNITE DE RECEPTION

UTILISATION ← DECODEUR DE SOURCE ← DECODEUR DE CANAL ← DEMODU-LATEUR

## FIG_2

A

111 = 7

in+1 | in | in-1   ~ Registre à décalage

101 = 5

B

## FIG_3

In In-1 (00) ①

0=00

(00)    (00)    (00)    (00)    (00)

(11) ②

(11)    (11)    (11)    (11)    (11)

1=10

(10)    (10)    (10)    (10)

2=01

(01)    (01)    (01)    (01)

(01)    (01)    (01)    (01)

3=11

(10)    (10)    (10)    (10)

Temps 0     1     2     3     4     5

## FIG_4b

$n$ —— $b(n,2n)$ —→ $2n$

$b(n, 2^{m-1}, 2n)$

$b(n, 2n+1)$

$n+2^{m-1}$ ——→ $2n+1$

$b(n+2^{m-1}, 2n+1)$

## FIG_4a

$m+1$

$m-1$

$n$

## FIG_4c

$n$ —— $b(n,2n)$ —→ $2n$

$b(n, 2n+1)$

$b(n, 2n+1)$

$n+2^{m-1}$ ——→ $2n+1$

$b(n,2n)$

## FIG_5

$0=00\,x$ —— $bm(0,0)$ —→ $x\,00=0$ $\quad =bm(0)$

$bm(\underline{1},1)\quad =bm(3)$

$\underline{bm(1,1)}\quad =bm(3)$

$1=10\,x$ $\qquad x\,10=1$

$bm(\underline{0},0)\quad =bm(0)$

$\underline{bm(1,0)}\quad =bm(\cancel{1})$

$2=01\,x$ $\qquad x\,0,1=2$

$bm(\underline{0},1)\quad =bm(\cancel{2})$

$bm(\underline{0},1)\quad =bm(\cancel{2})$

$3=1,1\,x$ —— $bm(1,0)$ —→ $x\,11=3$ $\quad =bm(\cancel{1})$

Codage [ S ]  décodage [ [S] ]

1 → 2

dépistage [ noeud r ]  [ noeud S ]

2 → 1

$2^m$  $m$

1

## FIG_7

| étape | symboles reçus | bm 0 00 | bm 1 10 | bm 2 01 | bm 3 11 | pm0 00 | pm0 + bm0 | pm2 + bm3 | surv0 | pm1 10 | pm0 + bm3 | pm2 + bm0 | surv1 | pm2 01 | pm1 + bm2 | pm3 + bm1 | surv2 | pm3 11 | pm1 + bm1 | pm3 + bm2 | surv3 |
|---|---|---|---|---|---|---|---|---|---|---|---|---|---|---|---|---|---|---|---|---|---|
| 1 | 00 | 0 | 1 | 1 | 2 | 0 | (0) | 2 | [0] | 0 | 2 | (0) | [2] | 0 | (1) | 1 | 0 | 0 | (1) | 1 | 0 |
| 2 | 10 | 1 | 0 | 2 | 1 | 0 | (1) | 2 | [0] | 0 | (1) | 2 | 0 | 1 | (0) | 3 | [0] | 1 | 2 | (1) | 1 |
| 3 | 00 | 0 | 1 | 1 | 2 | 1 | (1) | 2 | [0] | 1 | 3 | (0) | [1] | 0 | (2) | 2 | 0 | 1 | (2) | 2 | 0 |
| 4 | 01 | 1 | 2 | 0 | 1 | 1 | (2) | 3 | [0] | 0 | (2) | 3 | 0 | 2 | (2) | 2 | 0 | 2 | (0) | 3 | [0] |
| 5 | 10 | 1 | 0 | 2 | 1 | 2 | (3) | 3 | [0] | 2 | (3) | 3 | 0 | 2 | (2) | 2 | 0 | 0 | 4 | (0) | [1] |
| 6 | 00 | 0 | 1 | 1 | 2 | 3 | (3) | 4 | [0] | 3 | 5 | (2) | 1 | 2 | (4) | (1) | 1 | 0 | 4 | (1) | [1] |
| 7 | 00 | 0 | 1 | 1 | 2 | 3 | (3) | 3 | [0] | 2 | 5 | (1) | 1 | 1 | (3) | (2) | [1] | 1 | 3 | (2) | 1 |
| 8 | 00 | 0 | 1 | 1 | 2 | 3 | (3) | 4 | [0] | 1 | 5 | (2) | [1] | 2 | (2) | 3 | 0 | 2 | (2) | 3 | |
| 9 | 00 | 0 | 1 | 1 | 2 | 3 | (3) | 4 | [0] | 2 | 5 | (2) | 1 | 2 | (3) | 3 | [0] | 2 | (3) | 3 | 0 |
| 10 | 00 | 0 | 1 | 1 | 2 | 3 | (3) | 5 | [0] | 2 | 5 | (3) | [1] | 3 | (3) | 4 | 0 | 3 | (3) | 4 | 0 |
| 11 | 00 | 0 | 1 | 1 | 2 | 3 | (3) | 5 | [0] | 3 | 5 | (3) | 1 | 3 | (4) | 4 | [0] | 3 | (4) | 4 | 0 |
| 12 | 00 | 0 | 1 | 1 | 2 | 3 | (3) | 6 | [0] | 3 | 5 | (4) | [1] | 4 | (4) | 5 | 0 | 4 | (4) | 5 | 0 |
| 13 | 00 | 0 | 1 | 1 | 2 | 3 | (3) | 6 | [0] | 4 | 5 | (4) | 1 | 4 | (5) | 5 | 0 | 4 | (5) | 5 | [0] |

FIG_6

EP 0 700 164 B1

FIG_9

## FIG_8

A —s/→ [BMC] —4×b→ [PMC] —m→ [SSU] —d/→ [OD] →

B —s/→

## FIG_10

[MA] → [ACS] → [MB]

↕

[MB] → [ACS] → [MA]

## FIG_11

decoded bits

surv. —$2^m$/→ in [MEMOIRE 16] out —$2^m$/→ [mx 21] —1/→ [Shift reg 23]

[up cntr 17] → [mux] ← [down cntr 18]

[shift 22]

[mux 19] [20]

starting node

ST

## FIG_12

## FIG_13

FIG_14